# EUROPÄISCHE PATENTSCHRIFT

(11) **EP 2 518 316 B1**
(45) Veröffentlichungstag und Bekanntmachung des Hinweises auf die Patenterteilung: **19.03.2014**
(21) Anmeldenummer: 11003503.7
(22) Anmeldetag: 28.04.2011
(51) Int. Cl.: F03G 6/06, F24J 2/12, F24J 2/54

(54) **Tragevorrichtung für eine Solargeneratoreinheit**
Mounting device for a solar generator unit
Dispositif de support pour une unité de générateur solaire

(43) Veröffentlichungstag der Anmeldung: 31.10.2012
(73) Patentinhaber: AZURSPACE Solar Power GmbH, 74072 Heilbronn (DE)
(72) Erfinder: Löckenhoff, Rüdiger, Dr., 74321 Bietigheim-Bissingen (DE)
(74) Vertreter: Koch Müller Patentanwaltsgesellschaft mbH

(56) Entgegenhaltungen:
- WO-A1-02/079793
- US-A- 4 395 581
- US-A- 4 548 195

## Beschreibung

Die Erfindung betrifft eine Solargeneratoreinheit gemäß dem Oberbegriff des Patentanspruchs 1.

Eine Solargeneratoreinheit mit einer zweiachsigen Nachführung ist bekannt, siehe z.B. auch WO 02/079793. Hierbei ist die Spiegelanordnung an einem Mast angeordnet. Aus der EP 2 180 524 A2 ist eine weitere Solarzellenanordnung bestehend aus flachen Modulen bekannt. Die einzelnen Module weisen eine Vielzahl von einzelnen Solarzellen auf, wobei das Licht mittels einer abbildenden Optik auf die unterhalb der Optik angeordneten Solarzellen gebündelt wird.

Des Weiteren sind aus der US 4 548 195 A, welche als nächstliegender Stand der Technik anzusehen ist, und der US 4 395 581 A weiterer Solargeneratoreinheiten bekannt. Der Lichtkonverter ist mit einer Haltevorrichtung starr mit der Unterlage verbunden oder mit den Spiegelflächen verbunden.

Vor diesem Hintergrund besteht die Aufgabe der Erfindung darin, eine Vorrichtung anzugeben, die den Stand der Technik weiterbildet.

Die Aufgabe wird durch eine Solargeneratoreinheit mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Solargeneratoreinheit zur Konvertierung von Sonnenlicht offenbart, mit
- einer Spiegelanordnung, ausgebildet zur Bündelung des empfangenen Sonnenlichts,
- einem Lichtkonverter,
- einer Tragevorrichtung ausgebildet zur Halterung der Spiegelanordnung,
- einer Nachführungseinheit ausgebildet zur Nachführung der Spiegelanordnung an den tageszeitlichen Sonnenstand, wobei der Lichtkonverter in Richtung des einfallenden Sonnenlichtes oberhalb der Spiegelanordnung angeordnet ist und das gebündelte Licht auf eine Empfangsfläche des Lichtkonverters fällt und
die Tragevorrichtung eine im Wesentlichen horizontal angeordnete erste Welle aufweist und die erste Welle einen auf einander gegenüberliegenden Seiten der Spiegelanordnung angeordneten ersten radialen Lagerpunkt und zweiten radialen Lagerpunkt aufweist, und
der erste Lagerpunkt und der zweite Lagerpunkt mit der Mittelachse der ersten Welle fluchten, und
zwischen dem ersten Lagerpunkt und dem zweiten Lagerpunkt ein dritter radialer Lagerpunkt zur Aufnahme einer im Wesentlichen senkrecht zu der ersten Welle ausgebildeten zweiten Welle angeflanscht ist, so dass die Drehachse der zweiten Welle bei einer Drehung der ersten Welle mit verschwenkt wird, und
die Spiegelanordnung mit der zweiten Welle kraftschlüssig verbunden ist, und
die erste Welle die Gewichtskraft der zweiten Welle und der Spiegelanordnung aufnimmt, und
die Spiegelanordnung mehrere Segmente aufweist und zwischen einem Teil der Segmente ein Spalt ausgebildet ist, und
der Spalt eine lichte Weite von wenigstens dem Durchmesser der ersten Welle aufweist, und
die Nachführungseinheit ausgebildet ist, die Nachführung der Spiegelanordnung mittels einer Drehung der ersten Welle und der zweiten Welle durchzuführen,
und wobei
der Lichtkonverter mit der Spiegelanordnung starr gekoppelt ist, so dass bei einer Nachführung der Spiegelanordnung der Lichtkonverter mitgeführt wird, und
der Lichtkonverter mit der zweiten Welle kraftschlüssig und starr verbunden ist, so dass die erste Welle auch die Gewichtskraft des Lichtkonverters aufnimmt.

Ein Vorteil der erfindungsgemäßen Vorrichtung ist es, dass die Solargeneratoreinheit eine modulare Anordnung ausbildet und die modulare Anordnung sich einfach und kostengünstig herstellen und aufbauen lässt. Durch die neuartige besonders flache Konstruktion, insbesondere bedingt durch eine erste horizontal ausgebildete Welle, ist bereits eine geringe Höhe über einer Unterlage für die Spiegelanordnung ausreichend. Hierbei ist die erste Welle an den beiden Enden, vorzugsweise unterhalb der jeweiligen Lagerpunkte mit der Unterlage mittels einer stabförmigen Befestigung kraftschlüssig verbunden. Des Weiteren weisen die einzelnen Teile ein geringes Eigengewicht auf, so dass sich die Solargeneratoreinheit im Vergleich zu einer mastförmigen Anordnung ohne spezielle Hebevorrichtungen wie Kräne an Ort und Stelle aufbauen lässt. Insbesondere indem die Spiegelanordnung in einzelne Segmente aufgeteilt ist und die Segmente gemäß einer bevorzugten Ausführungsform sich beidseitig bodennah um eine zweite Welle anordnen, lässt sich bei der erfindungsgemäßen Anordnung die Windlast der gesamten Anordnung im Vergleich zu einer einzelnen mastförmigen Anordnung erheblich reduzieren. Weiterhin lassen sich die einzelnen Segmente derart ausführen, dass die strukturelle Integrität bzw. die Durchbiegung aufgrund des eigenen Gewichtes kleiner ist, als eine großen Spiegelflächen, die sich unter dem eigenen Gewicht verbiegen, so dass je nach der Ausrichtung der Spiegelanordnung bevorzugt die äußeren Teile der Spiegelflächen nicht mehr präzise ausgerichtet sind.

Untersuchungen der Anmelder in haben gezeigt, dass durch die besondere Anordnung von zwei Drehachsen, bei einer Drehung der ersten Welle und der hierdurch verbundenen Verschwenkung der zweiten Welle, bereits mit kleinen Drehbewegungen bei den beiden Wellen eine Nachführung der Spiegelanordnung an den tageszeitlichen Sonnenstand erzielen lässt. Insbesondere ist die Anordnung für Gebiete mit einem Breitengrad kleiner als 40° bevorzugt geeignet. Hierzu wird die erste Welle vorzugsweise in Nord-Süd-Richtung angeordnet. Während eines Tages wird die Nachführung mittels des ersten Aktuators durchgeführt, um der Sonne bei ihrem Weg über den Zenit zu folgen. Der zweite Aktuator an der zweiten Welle führt währenddessen von Zeit zu Zeit im Vergleich zu den Bewegungen des ersten Aktuators nur kleine Korrekturen aus.

In einer möglichen Ausführungsform (nicht im Anspruchssatz enthalten) wird die erste Welle aus der Nord-Süd-Richtung um einen gewissen Winkel herausgedreht. Die Abweichung lässt sich ohne Weiteres mittels einer Drehung der zweiten Welle ausgleichen. Hierdurch lässt sich die Solargeneratoreinheit auch auf Unterlagen, wie beispielsweise einer Dachfläche anordnen, welche keine exakte Nord-Süd Richtung aufweisen.

Ein weiterer Vorteil der Segmentierung der Spiegelanordnung ist es, dass sich Spalte zwischen den einzelnen Segmenten der Spiegelanordnung ausbilden lassen, so dass bei einer Rotation des Solargenerators um die Achse der zweiten Welle eine Kollision der einzelnen Segmente der Spiegelanordnung mit der ersten Welle ausgeschlossen ist.

Ein anderer Vorteil der segmentierten Anordnung ist es, dass sich der Lichtkonverter und die Haltevorrichtung des Lichtkonverters derart oberhalb der Spiegelanordnung positionieren lassen, dass der Schattenwurf der beiden Teile in einen Spalt zwischen den Segmenten fällt. Hierdurch lässt sich der Wirkungsgrad der Anordnung erhöhen und gleichzeitig teure Spiegelfläche einsparen.

In einer Weiterbildung sind die Wellen als Torsionsrohre ausgebildet. Alternativ lassen sich auch Stäbe oder Mehrkantstangen verwenden. Des Weiteren ist es bevorzugt, alle Segmente der Spiegelanordnung an bzw. mit der zweiten Welle kraftschlüssig anzuordnen.

In einer Ausführungsform ist es bevorzugt, dass ein Teil der mit der zweiten Welle verbundenen Segmente der Spiegelanordnung einen Spalt ausbilden und der Spalt eine lichte Weite von wenigstens dem Durchmesser der zweiten Welle aufweist. Hierzu sind auf beiden Seiten der zweiten Welle je zwei Segmente der Spiegelanordnung angeordnet. In Bezug zur ersten Welle sind ebenfalls je zwei der Spiegel an beiden Seiten der ersten Welle angeordnet. Jedoch sind alle Segmente nur mit der zweiten Welle kraftschlüssig und starr verbunden. In Bezug auf die zweite Welle teilt die erste Welle die zweite Welle in zwei vorzugsweise gleich lange Hälften, so dass mit jeder Hälfte der zweiten Welle zwei Segmente der Spiegelanordnung starr verbunden sind. Untersuchungen der Anmelderin haben gezeigt, dass es bevorzugt ist, genau vier gleich große Spiegelsegmente zu verwenden, wobei die Segmente als Teil einer Parabolspiegelanordnung ausgebildet sind, die das Licht auf eine Empfangsfläche des Lichtkonverters bündeln. Des Weiteren ist es bevorzugt, dass jeweils zwei Segmente einen Spalt ausbilden, entweder zur Aufnahme der ersten Welle oder der zweiten Welle. Dabei kann jedes der vier Spiegelsegmente entweder aus einer ununterbrochenen Spiegelfläche bestehen oder aus mehreren Untersegmenten zusammengesetzt sein.

Gemäß einer anderen Weiterbildung, ist das dritte Lager in Bezug auf die Längserstreckung der zweiten Welle im Wesentlichen in der Mitte angeflanscht. Vorzugsweise ist die Tragevorrichtung ausgebildet, die Gewichtskraft der mit der zweiten Welle verbundenen Segmente ausschließlich auf die erste Welle zu übertragen. Es ist des Weiteren bevorzugt, den Schwerpunkt der Spiegelanordnung im Wesentlichen auf der Drehachse der ersten Welle und / oder der zweiten Welle zu legen. Hierdurch werden eine geringe Windlast und eine hohe mechanische Belastbarkeit der gesamten Solargeneratoreinheit erzielt.

In einer Weiterbildung weist die erste Welle zur Drehung einen ersten Aktuator auf. Des Weiteren weist die zweite Welle zur Drehung ebenfalls einen zweiten Aktuator auf. Die beiden Aktuatoren sind mit der Nachführungseinheit verbunden und werden von der Nachführungseinheit derart gesteuert, dass die Spiegelanordnung mit dem Lichtkonverter jeweils zu Sonne exakt ausgerichtet ist. Es ist bevorzugt, jeweils nur einen einzigen Aktuator je Welle vorzusehen.

In einer anderen Ausführungsform sind mehrere Solargeneratoreinheiten gemeinsam auf einer ersten Welle angeordnet, so dass zur Verschwenkung von mehreren zweiten Wellen ein einzelner erster Aktuator ausreicht. Des Weiteren ist es bevorzugt, mehrere zweite Wellen derart miteinander zu koppeln, dass bei einer Drehung der zweiten Welle die Weiteren gekoppelten zweiten Wellen mitgedreht werden. Vorzugsweise erfolgt die Verkopplung nach dem Prinzip der Parallelogrammführung. Dazu werden vorzugsweise die Lichtkonverter mit einer Schubstange kraftschlüssig derart verbunden, dass ihr Abstand beim Drehen der zweiten Wellen konstant bleibt.

Gemäß einer bevorzugten Ausführungsform umfasst der Lichtkonverter eine Solarzelle, insbesondere eine Trippel-Solarzelle oder einen Dampferzeuger.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine schematische Ansicht auf eine erste erfindungsgemä-ße Ausführungsform einer Solargeneratoreinheit,
- Figur 2: eine schematische Ansicht auf eine zweite erfindungsge-mäße Ausführungsform einer Solargeneratoreinheit.

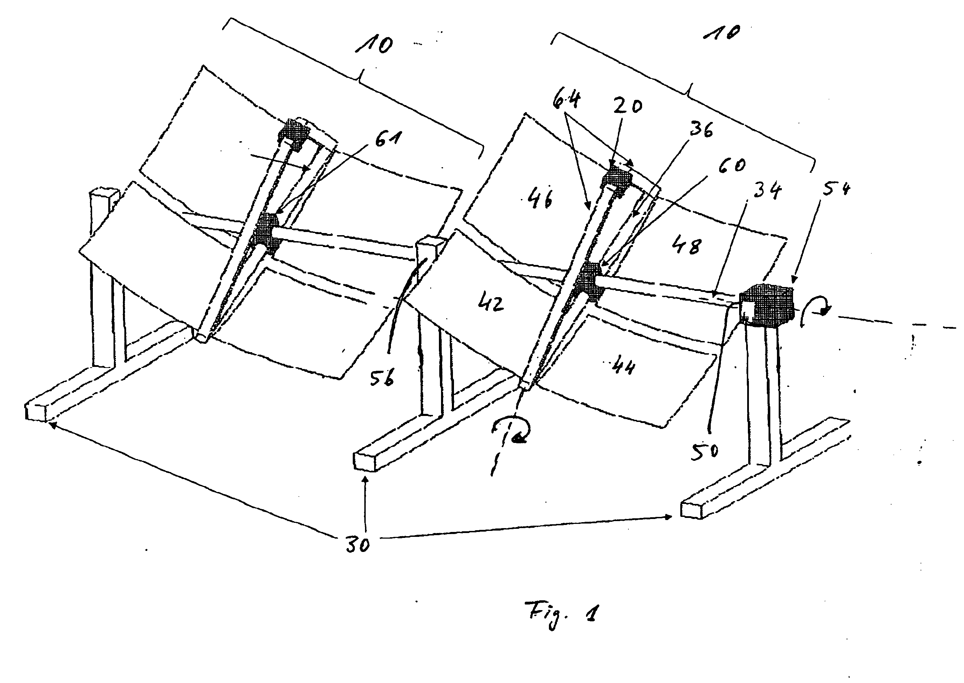

Die Abbildung der Figur 1 zeigt eine schematische Ansicht einer ersten Ausführungsform, aufweisend eine Solargeneratoreinheit 10 mit einem Lichtkonverter 20, eine Tragevorrichtung 30 mit einer ersten horizontalen Welle 34 und einer an die erste Welle 34 angeflanschten zweiten Welle 36 und einer Spiegelanordnung mit vier Segmenten 42, 44, 46 und 48 und einer Nachführungseinheit- nicht dargestellt. Die vier Segmente 42, 44, 46 und 48 bilden vorzugsweise einen Teil eines Parabolspiegels aus. Die erste Welle 34 weist einen ersten Lagerpunkt 50 mit einem ersten Aktuator 54 und einen zweiten Lagerpunkt 56 auf. Der erste Lagerpunkt 50 und der zweite Lagerpunkt 56 sind als Radiallager ausgebildet und umfassen vorzugsweise jeweils ein Wälzlager und fluchten mit der Mittelachse der ersten Welle. Zwischen dem ersten Lagerpunkt 50 und dem zweiten Lagerpunkt 56 sind die vier Segmente 42, 44, 46 und 48 der Spiegelanordnung ausgebildet, wobei die Segmente 42, 44, 46 und 48 ausschließlich mit der zweiten Welle 36 kraftschlüssig und bevorzugt starr verbunden sind. Die zweite Welle 36 weist an dem Anflanschpunkt mit der ersten Welle 34 einen dritten Lagerpunkt mit einem zweiten Aktuator 60 auf und ist hinsichtlich der Längserstreckung in der Mitte mit der ersten Welle 34 verbunden. Es ist bevorzugt, dass der dritte Lagerpunkt ein Radiallager umfasst. Oberhalb der Segmente 42, 44, 46 und 48 ist in der Brennfläche der Spiegelanordnung eine Empfangsfläche des Lichtkonverters 20 angeordnet. Der Lichtkonverter 20 ist mittels einer stangenförmigen Haltervorrichtung 64 kraftschlüssig und starr mit der zweiten Welle 36 verbunden. Zwischen den einzelnen Segmenten ist jeweils ein Spalt zur Aufnahme der ersten Welle 34 oder zur Aufnahme der zweiten Welle 36 ausgebildet. Indem jeweils zwei der vier Segmente 42, 44, 46 und 48 auf einer Seite entweder der ersten Welle 34 oder einer Seite der zweiten Welle 36 der Spiegelanordnung angeordnet sind, ist der Schwerpunkt der Spiegelanordnung im Wesentlichen In der Nähe oder auf der Achse der ersten Welle 34 ausgebildet.

Indem der Lichtkonverter starr mit der zweiten Welle 36 gekoppelt ist, wird bei einer Nachführung der Spiegelanordnung mittels Drehung der ersten Welle 34 und / oder der zweiten Welle 36 der Lichtkonverter 20 mitbewegt. Hierdurch wird gewährleistet, dass die Empfangsfläche des Lichtkonverters 20 immer in der Brennfläche der Spiegelanordnung positioniert ist. Die Drehung der Wellen erfolgt 34, 36 mittels einer Ansteuerung des ersten Aktuators 54 und einer Ansteuerung des zweiten Aktuators 60 durch die mit den Aktuatoren elektrisch verbundene Nachführungseinheit.

Infolge der besonderen Anordnung der Segmente 42, 44, 46 und 48 als Quadranten eines Kreuzes lässt sich eine Kollision der Spiegelflächen mit einen der beiden Wellen 34, 36 ausschließen. Außerdem fällt bei entsprechender Auslegung der Schatten der Wellen bei Sonnenausrichtung immer in den Spalt zwischen zwei Segmente. Auf diese Weise wird eine Abschattung der Segmente vermieden. Insbesondere in äquatornahen geographischen Regionen mit einem Breitengrad kleiner als 40° vorzugsweise kleiner als 30°, in denen die Sonne den Zenit überquert, weist die erfindungsgemäße Anordnung besondere Vorteile auf. Hierzu wird das die erste Welle 34 vorzugsweise im Wesentlichen in Nord-Süd-Richtung angeordnet.

Es ist vorteilhaft, mehrere Solargeneratoreinheiten 10 auf einer ersten Welle 10 anzuordnen, wie in der Figur 1 am Beispiel mit zwei Solargeneratoreinheiten 10 dargestellt. Die Nachführung an der ersten Welle 34 erfolgt vorzugsweise mit dem ersten Aktuator 54, während die zweite Welle 36 der weiteren Solargeneratoreinheit 10 einen separaten Aktuator 61 aufweist. Hiernach wird eine zweiachsige Sonnennachführung der beiden Solargeneratoren 10 mit nur drei Aktuatoren anstelle von vier Aktuatoren durchgeführt und hierdurch lassen sich erhebliche Kosten einsparen.

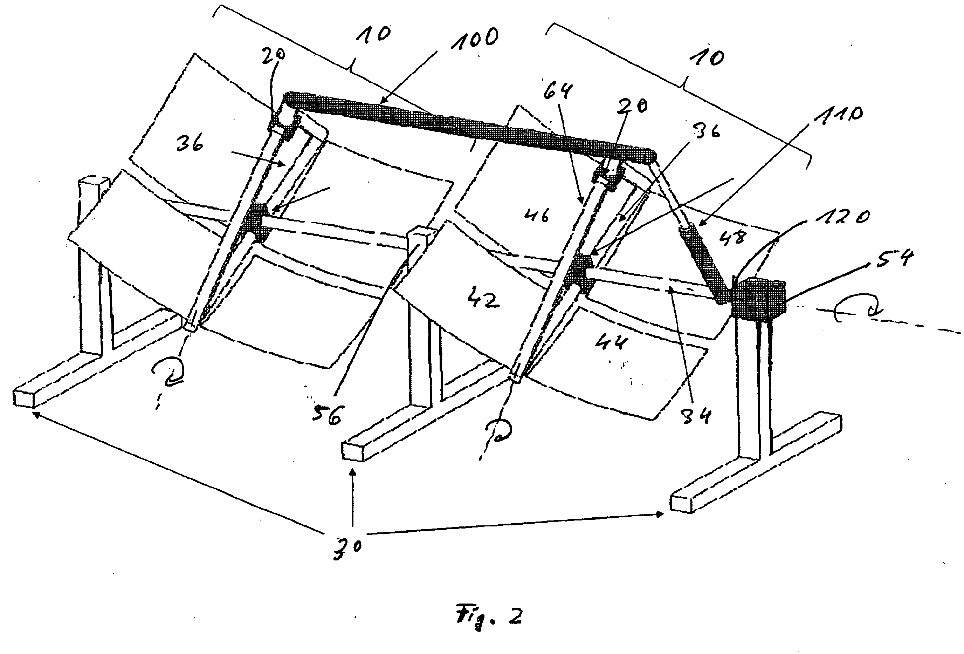

In der Abbildung der Figur 2 ist eine weitere Ausführungsform einer vorteilhaften Aneinanderreihung von zwei Solargeneratoreinheiten 10 dargestellt. Im Folgenden werden nur die Unterschiede zu der Abbildung der Figur 1 erläutert. An die Lichtkonverter 20 der einzelnen Solargeneratoreinheiten sind mittels einer mechanischen Haltervorrichtung 100, die vorzugsweise eine Schubstange umfasst, nach Art einer Parallelogrammführung kraftschlüssig gekoppelt. Des Weiteren erübrigen sich die zweiten Aktuatoren 60, 61 an den zweiten Wellen 36, d.h. die zweiten Wellen sind jeweils nur radial gelagert. Die beiden zweiten Wellen 36 der Solargeneratoreinheiten 10 sind mittels der mechanischen Haltevorrichtung 100 neben der Kopplung mittels der ersten Welle 34 zusätzlich gekoppelt. Die mechanische Haltevorrichtung 100 ist mittels einer in der Länge durch Drehung veränderbaren Stange 110 mit einem Aktuator 120 gekoppelt. Indem der Aktuator 120 die Stange 110 um deren Längsachse dreht, werden die zweiten Wellen mittels einer horizontalen Lageänderung der Schubstange 100 um deren Drehachsen gedreht. Insgesamt werden zur Nachführung der zwei Solargeneratoreinheiten 10 nur zwei Aktuatoren benötigt.

Es sei angemerkt, dass auch mehr als zwei Solargeneratoreinheiten anfügbar sind und beispielsweise gemäß der Ausführungsform der Abbildung der Figur 2 sämtliche Spiegelanordnungen mit nur zwei Aktuatoreinheiten dem Sonnenstand nachführbar sind.

## Patentansprüche

1. Solargeneratoreinheit (10) zur Konvertierung von Sonnenlicht, mit
- einer Spiegelanordnung, ausgebildet zur Bündelung des empfangenen Sonnenlichts,
- einem Lichtkonverter (20),
- einer Tragevorrichtung (30) ausgebildet zur Halterung der Spiegelanordnung,
- einer Nachführungseinheit ausgebildet zur Nachführung der Spiegelanordnung an den tageszeitlichen Sonnenstand, wobei
der Lichtkonverter (20) in Richtung des einfallenden Sonnenlichtes oberhalb der Spiegelanordnung angeordnet ist und das gebündelte Licht auf eine Empfangsfläche des Lichtkonverters (20) fällt
und
die Tragevorrichtung eine Im Wesentlichen horizontal angeordnete erste Welle (34) aufweist und die erste Welle (34) einen auf einander gegenüberliegenden Seiten der Spiegelanordnung angeordneten ersten radialen Lagerpunkt (50) und zweiten radialen Lagerpunkt (56) aufweist, und
der erste Lagerpunkt (50) und der zweite Lagerpunkt (56) mit der Mittelachse der ersten Welle fluchten (34), und zwischen dem ersten Lagerpunkt (50) und dem zweiten Lagerpunkt (56) ein dritter radialer Lagerpunkt zur Aufnahme einer im Wesentlichen senkrecht zu der ersten Welle (34) ausgebildeten zweiten Welle (36) angeflanscht ist, so dass die Drehachse der zweiten Welle (36) bei einer Drehung der ersten Welle (34) mit verschwenkt wird, und die Spiegelanordnung mit der zweiten Welle (36) kraftschlüssig verbunden ist, und
die erste Welle (34) die Gewichtskraft der zweiten Welle (36) und der Spiegelanordnung aufnimmt, und
die Spiegelanordnung mehrere Segmente (42, 44, 46, 48) aufweist und zwischen einem Teil der Segmente (42, 44, 46, 48) ein Spalt ausgebildet ist, und
der Spalt eine lichte Weite von wenigstens dem Durchmesser der ersten Welle (34) aufweist,
und die Nachführungseinheit ausgebildet ist, die Nachführung der Spiegelanordnung mittels einer Drehung der ersten Welle (34) und der zweiten Welle (36) durchzuführen,
**dadurch gekennzeichnet, dass**
der Lichtkonverter (20) mit der Spiegelanordnung starr gekoppelt ist, so dass bei einer Nachführung der Spiegelanordnung der Lichtkonverter (20)
mitgeführt wird,
und der Lichtkonverter (20) mit der zweiten Welle (36) kraftschlüssig und starr verbunden ist, so dass
die erste Welle (34) auch die Gewichtskraft des Lichtkonverters (20) aufnimmt.

2. Solargeneratoreinheit nach Anspruch 1, **dadurch gekennzeichnet, dass** die Wellen (34, 36) als Torsionsrohre ausgebildet sind.

3. Solargeneratoreinheit nach Anspruch 1 oder Anspruch 2, **dadurch gekennzeichnet, dass** an der zweiten Welle (36) alle Segmente der Spiegelanordnung kraftschlüssig angeordnet sind.

4. Solargeneratoreinheit nach einem der Ansprüche 1 bis 3, **dadurch gekennzeichnet, dass** ein Teil der mit der zweiten Welle (36) verbundenen Segmente der Spiegelanordnung ein Spalt ausbilden und der Spalt eine lichte Weite von wenigstens dem Durchmesser der zweiten Welle (36) aufweist.

5. Solargeneratoreinheit nach einem der Ansprüche 1 bis 4, **dadurch gekennzeichnet, dass** das dritte Lager in einem dritten Lagerpunkt in Bezug auf die Längserstreckung der zweiten Welle (36) im Wesentlichen in der Mitte der zweiten Welle (36) angeflanscht ist.

6. Solargeneratoreinheit nach einem der Ansprüche 1 bis 5, **dadurch gekennzeichnet, dass** die Tragevorrichtung ausgebildet Ist, die Gewichtskraft der mit der zweiten Welle (36) verbundenen Segmente ausschließlich auf die erste Welle (34) zu übertragen.

7. Solargeneratoreinheit nach einem der Ansprüche 1 bis 6, **dadurch gekennzeichnet, dass** der Schwerpunkt der Spiegelanordnung im Wesentlichen auf der Drehachse der ersten Welle (34) liegt.

8. Solargeneratoreinheit nach einem der Ansprüche 1 bis 7, **dadurch gekennzeichnet, dass** die Spiegelanordnung vier Segmente, die das Licht auf eine Empfangsfläche des Lichtkonverters (20) bündeln, aufweist und jeweils zwei Segmente einen Spalt zur Aufnahme einer der Wellen (34, 36) ausbilden.

9. Solargeneratoreinheit nach einem der Ansprüche 1 bis 8, **dadurch gekennzeichnet, dass** die Spiegelanordnung genau vier Segmente aufweist und an jeder Hälfte der zweiten Welle (36) zwei Segmente starr verbunden sind.

10. Solargeneratorelnheit nach einem der vorstehenden Ansprüche, **dadurch gekennzeichnet, dass** die erste Welle (34) zur Drehung einen einzigen Aktuator (54) aufweist.

11. Solargeneratoreinheit nach einem der Ansprüche 1 bis 10, **dadurch gekennzeichnet, dass** die zweite Welle (36) zur Drehung einen einzigen Aktuator (60, 61) aufweist.

12. Solargeneratoreinheit nach einem der Ansprüche 1 bis 11, **dadurch gekennzeichnet, dass** mehrere Solargeneratoreinheiten (10) auf einer gemeinsamen ersten Welle (34) angeordnet sind.

13. Solargeneratoreinheit nach einem der Ansprüche 2 bis 12, **dadurch gekennzeichnet, dass** mehrere zweite Wellen (36) vorgesehen sind und die mehreren zweiten Wellen (36) miteinander gekoppelt sind, so dass bei Drehung einer von den mehreren zweiten Wellen (36) um die Wellenachse die gekoppelten zweiten Wellen (36) mitgedreht werden.

14. Solargeneratoreinheit nach einem der vorstehenden Ansprüche, **dadurch gekennzeichnet, dass** der Lichtkonverter (20) eine Solarzelle oder einen Dampferzeuger umfasst.

## Claims

1. Solar generator unit (10) for converting sunlight, comprising
- a reflector arrangement constructed for focusing received sunlight,
- a light converter (20),
- a support device (30) constructed for mounting the reflector arrangement,
- a tracking unit constructed for tracking the reflector arrangement to the time-of-day state of the sun, wherein the light converter (20) is arranged in the direction of the incident sunlight above the reflector arrangement and the focused light impinges on a receiving surface of the light converter (20) and
the support device comprises a substantially horizontally arranged first shaft (34) and the first shaft (34) has a first radial bearing point (50) and second radial bearing point (56) arranged on mutually opposite sides of the reflector arrangement and
the first bearing point (50) and the second bearing point (56) are aligned with the centre axis of the first shaft (34), and
a third radial bearing point for mounting a second shaft (36) constructed substantially perpendicularly to the first shaft (34) is flange-mounted between the first bearing point (50) and the second bearing point (56) so that the axis of rotation of the second shaft (36) is subject to accompanying pivotation when the first shaft (34) is rotated, and
the reflector arrangement is mechanically positively connected with the second shaft (36), and
the first shaft (34) accepts the weight force of the second shaft (36) and the reflector arrangement, and
the reflector arrangement comprises a plurality of segments (42, 44, 46, 48) and a gap is formed between a part of the segments (42, 44, 46, 48), and
the gap has a clear width of at least the diameter of the first shaft (34), and
the tracking unit is constructed to perform tracking of the reflector arrangement by means of rotation of the first shaft (34) and the second shaft (36),
**characterised in that**
the light converter (20) is rigidly coupled with the reflector arrangement so that the light converter (20) is subject to accompanying guidance when the reflector arrangement is tracked and
the light converter (20) is mechanically positively and rigidly connected with the second shaft (36), so that the first shaft (34) also accepts the weight force of the light converter (20).

2. Solar generator unit according to claim 1, **characterised in that** the shafts (34, 36) are constructed as torsion tubes.

3. Solar generator unit according to claim 1 or claim 2, **characterised in that** all segments of the reflector arrangement are mechanically positively arranged at the second shaft (36).

4. Solar generator unit according to any one of claims 1 to 3, **characterised in that** a part of the segments, which are connected with the second shaft (36), of the reflector arrangement form a gap and the gap has a clear width of at least the diameter of the second shaft (36).

5. Solar generator unit according to any one of claims 1 to 4, **characterised in that** the third bearing is flange-mounted at a third bearing point substantially in the centre of the second shaft (36) with respect to the length direction of the second shaft (36).

6. Solar generator unit according to any one of claims 1 to 5, **characterised in that** the support device is constructed to transfer weight force of the segments, which are connected with the second shaft (36), exclusively to the first shaft (34).

7. Solar generator unit according to any one of claims 1 to 6, **characterised in that** the centre of gravity of the reflector arrangement lies substantially on the axis of rotation of the first shaft (34).

8. Solar generator unit according to any one of claims 1 to 7, **characterised in that** the reflector arrangement comprises four segments, which focus the light onto a receiving surface of the light converter (20), and each two segments form a gap for receiving one of the shafts (34, 36).

9. Solar generator unit according to any one of claims 1 to 8, **characterised in that** the reflector arrangement comprises exactly four segments and two segments are rigidly connected with each half of the second shaft (36).

10. Solar generator unit according to any one of the preceding claims, **characterised in that** the first shaft (34) has a single actuator (54) for the rotation.

11. Solar generator unit according to any one of claim 1 to 10, **characterised in that** second shaft (36) has a single actuator (60, 61) for the rotation.

12. Solar generator unit according to any one of claims 1 to 11, **characterised in that** a plurality of solar generator units (10) is arranged on a common first shaft (34).

13. Solar generator unit according to any one of claims 2 to 12, **characterised in that** a plurality of second shafts (36) is provided and the second shafts (36) of the plurality are coupled together so that on rotation of one or more second shafts (36) about the shaft axis the coupled second shafts (36) are rotated therewith.

14. Solar generator unit according to any one of the preceding claims, **characterised in that** the light converter (20) comprises a solar cell or a steam generator.

## Revendications

1. Unité de générateur solaire (10) pour la conversion de lumière solaire, avec
- une machine à miroirs, conçue pour la focalisation de la lumière solaire reçue,
- un convertisseur de lumière (20),
- un dispositif de support (30), conçu pour supporter la machine à miroirs,
- une unité de poursuite, conçue pour la poursuite de la position diurne du soleil avec la machine à miroirs, dans laquelle le convertisseur de lumière (20) est disposé au-dessus de la machine à miroirs dans la direction de la lumière solaire incidente et la lumière focalisée tombe sur une surface de réception du convertisseur de lumière (20), et
le dispositif de support présente un premier arbre (34) disposé essentiellement à l'horizontale et le premier arbre (34) présente un premier point d'appui radial (50) et un deuxième point d'appui radial (56) disposés sur des côtés opposés l'un à l'autre de la machine à miroirs, et
le premier point d'appui (50) et le deuxième point d'appui (56) sont en alignement avec l'axe central du premier arbre (34), et
un troisième point d'appui radial, destiné à recevoir un deuxième arbre (36) réalisé essentiellement à la perpendiculaire du premier arbre (34), est bridé entre le premier point d'appui (50) et le deuxième point d'appui (56), de telle manière que l'axe de rotation du deuxième arbre (36) pivote avec le premier arbre (34) lorsque celui-ci tourne, et
la machine à miroirs est assemblé par friction au deuxième arbre (36), et
le premier arbre (34) reprend le poids du deuxième arbre (36) et de la machine à miroirs, et
la machine à miroirs présente plusieurs segments (42, 44, 46, 48) et une fente est réalisée entre une partie des segments (42, 44, 46, 48), et
la fente présente une largeur libre égale au moins au diamètre du premier arbre (34), et
l'unité de poursuite est conçue de façon à exécuter la poursuite avec la machine à miroirs par une rotation du premier arbre (34) et du deuxième arbre (36), **caractérisée en ce que**
le convertisseur de lumière (20) est rigidement couplé à la machine à miroirs, de telle manière que le convertisseur de lumière (20) soit entraîné avec la machine à miroirs lors d'une poursuite,
et le convertisseur de lumière (20) est assemblé par friction et rigidement au deuxième arbre (36), de telle manière que le premier arbre (34) reprenne également le poids du convertisseur de lumière (20).

2. Unité de générateur solaire selon la revendication 1, **caractérisée en ce que** les arbres (34, 36) sont réalisés sous forme de tubes de torsion.

3. Unité de générateur solaire selon la revendication 1 ou la revendication 2, **caractérisée en ce que** tous les segments de la machine à miroirs sont disposés en assemblage par friction sur le deuxième arbre (36).

4. Unité de générateur solaire selon l'une quelconque des revendications 1 à 3, **caractérisée en ce qu'**une partie des segments de la machine à miroirs assemblés au deuxième arbre (36) forme une fente et la fente présente une largeur libre égale au moins au diamètre du deuxième arbre (36).

5. Unité de générateur solaire selon l'une quelconque des revendications 1 à 4, **caractérisée en ce que** le troisième palier est bridé en un troisième point d'appui essentiellement au milieu du deuxième arbre (36) par rapport à l'extension longitudinale du deuxième arbre (36).

6. Unité de générateur solaire selon l'une quelconque des revendications 1 à 5, **caractérisée en ce que** le dispositif de support est conçu de façon à transférer le poids des segments assemblés au deuxième arbre (36) exclusivement au premier arbre (34).

7. Unité de générateur solaire selon l'une quelconque des revendications 1 à 6, **caractérisée en ce que** le centre de gravité de la machine à miroirs est situé sensiblement sur l'axe de rotation du premier arbre (34).

8. Unité de générateur solaire selon l'une quelconque des revendications 1 à 7, **caractérisée en ce que** la machine à miroirs présente quatre segments, qui focalisent la lumière sur une surface de réception du convertisseur de lumière (20), et deux segments forment respectivement une fente destinée à recevoir l'un des arbres (34, 36).

9. Unité de générateur solaire selon l'une quelconque des revendications 1 à 8, **caractérisée en ce que** la machine à miroirs présente exactement quatre segments et deux segments sont assemblés rigidement à chaque moitié du deuxième arbre (36).

10. Unité de générateur solaire selon l'une quelconque des revendications précédentes, **caractérisée en ce que** le premier arbre (34) présente pour la rotation un actionneur unique (54).

11. Unité de générateur solaire selon l'une quelconque des revendications 1 à 10, **caractérisée en ce que** le deuxième arbre (36) présente pour la rotation un actionneur unique (60, 61).

12. Unité de générateur solaire selon l'une quelconque des revendications 1 à 11, **caractérisée en ce que** plusieurs unités de générateur solaire (10) sont disposées sur un premier arbre commun (34).

13. Unité de générateur solaire selon l'une quelconque des revendications 2 à 12, **caractérisée en ce qu'**il est prévu plusieurs deuxièmes arbres (36) et les multiples deuxièmes arbres (36) sont couplés entre eux, de telle manière que, lors de la rotation de l'un des multiples deuxièmes arbres (36) autour de l'axe de l'arbre, les deuxièmes arbres couplés (36) soient entraînés en rotation.

14. Unité de générateur solaire selon l'une quelconque des revendications précédentes, **caractérisée en ce que** le convertisseur de lumière (20) comprend une cellule solaire ou un générateur de vapeur.
